Europäisches Patentamt

European Patent Office    (11) Publication number:    **0 231 247**

Office européen des brevets    **B1**

(12)    **EUROPEAN PATENT SPECIFICATION**

(45) Date of publication of patent specification: **10.10.90**    (51) Int. Cl.⁵: **H 01 J 37/285, H 01 J 49/02, H 01 J 49/40**

(21) Application number: **86904320.8**

(22) Date of filing: **22.07.86**

(86) International application number:
**PCT/GB86/00437**

(87) International publication number:
**WO 87/00682 29.01.87 Gazette 87/03**

(54) **IMPROVEMENTS IN ATOM PROBES.**

(30) Priority: **23.07.85 GB 8518515**
**09.05.86 GB 8611376**

(43) Date of publication of application:
**12.08.87 Bulletin 87/33**

(45) Publication of the grant of the patent:
**10.10.90 Bulletin 90/41**

(84) Designated Contracting States:
**GB**

(56) References cited:
**US-A-3 819 941**
**US-A-3 868 507**

**IEEE Transactions on Nuclear Science, volume NS-31, no.1, February 1984, (IEEE, New York, US), O.H.W. Siegmund et al.: "Microchannel plate EUV detectors for the extreme ultraviolet explorer", pages 776-779**

(73) Proprietor: **SMITH, George David William**
**8 Tilgarsley Road**
**Eynsham Oxford (GB)**
(73) Proprietor: **CEREZO, Alfred**
**Wolfson College**
**Oxford (GB)**

(72) Inventor: **SMITH, George David William**
**8 Tilgarsley Road**
**Eynsham Oxford (GB)**
Inventor: **CEREZO, Alfred**
**Wolfson College**
**Oxford (GB)**

(74) Representative: **Smith, Martin Stanley et al**
**Stevens, Hewlett & Perkins 5, Quality Court**
**Chancery Lane**
**London WC2A 1HZ (GB)**

(56) References cited:

Instruments and Experimental Techniques, volume 27, no.1, part 1, January/February 1984, (Plenum Publishing Corporation, New York, US), M.A.GRUNTMAN: "Coordinate-sensitive detectors based on multichannel plates (review)", pages 1-19

Nuclear Instruments and Methods in Physics Research, volume 218, no.1/3, December 1983, (North-Holland Publishers B.V., Amsterdam, NL), pages 383-390

Journal of Physics E, volume 10, no.9, September 1977, (London,GB), T.M. Hall et al.: "A computer-controlled time-of-flight atom-probe field-ion microscope for the study of defects in metals", pages 884-893

**Description**

In the field-ion microscope (FIM) an image of atom positions on the surface of a sharply pointed specimen can be produced by the field ionisation of gas atoms close to the surface. Later developments have permitted analysis of the atoms visualised in the FIM by two broad means:

1) In the atom probe (AP), the specimen is moved so that the image of the atom or region of interest lies over the aperture into a mass spectrometer (either time-of-flight or magnetic sector). Typically this aperture would be a hole in the phosphorescent screen of the FIM and would cover the image of 10—100 atoms on the specimen surface. Ions field evaporated from the specimen surface, either by a voltage pulse, a laser pulse or a sufficiently high d.c. voltage, and passing through the aperture are analysed in the spectrometer.

2) The imaging atom probe (IAP) uses a combined detector and imaging screen placed close to the specimen. This detector can thus collect ions field evaporated from the whole of the imaged area. By using pulsed field evaporation, the resultant charge from the detector can be used as a time-of-flight analysis of the field evaporated layer. Alternatively, a time gating technique can be used to selectively image one kind of field evaporated species, that is ions having a given time-of-flight. Such a technique is described in United States patent specification No. 3868507. Here an imaging atom probe is provided with means (for example a camera) which may make an record of the global image of the screen when it represents arrival of ions in a particular time slot corresponding to a preselected species.

Additionally, in the above-mentioned patent specification there is described an arrangement employing a photomultiplier with a discrete field of view for observing a specific part of the screen corresponding to a specific part of the specimen and analysing the times of flight of the ions for that part to give an indication of their species. It will be seen that this corresponds to the atom probe (AP) approach.

It is the purpose of the present invention to extend the capabilities of the presently available techniques by incorporating the high spatial resolution of the AP with the extended field of view of the IAP. This involves a new detector and electronics system, which may include on-line computing facilities, allowing the simultaneous measurement of the positions of ion impact and the ion times-of-flight. Since position of ion impact can be related directly to the original location of the atom on the tip surface, both the chemistry and distribution of the surface species can be obtained. The resulting instrument is thus able to carry out analysis in either of the modes of previous instruments, and also produce selected images for any or all of the field evaporated species simultaneously. It also allows three-dimensional reconstruction of the microchemical variations within the specimen.

According to the invention there is provided an atom probe comprising a specimen holder for holding a specimen to be examined; means for field evaporating ions from the surface of the specimen; an ion detector arrangement for receiving the ions; a position detector responsive to the indicence of the ions on the detector arrangement; and timing means for determining the times-of-flight of the ions from the specimen to the detector arrangement and thereby allowing the ion species to be identified, characterised in that the position detector is effective to produce sequential electrical position signals representative of the position of incidence of the ions on the detector arrangement and further characterised in that correlating means are provided for serially processing the said position signals representative of different positions of incidence of the ions under the control of timing signals derived from the timing means so as to enable the species of each ion to be identified with the ion position.

This arrangement allows direct electrical signals to be obtained which represent the species and corresponding position of each ion, and thus atom. In contrast to the use of optical information derived from a phosphorescent screen, direct electrical signals are more efficient and are capable of electronic processing and correlation at speeds which allow a three-dimensional pattern of the specimen to be built up from ions which successively impinge upon the ion detector arrangement.

Preferably, the detector arrangement comprises a charged particle multiplier for producing a quantity of charged particles corresponding in amount and position to the number of ions incident and the respective positions of incidence of each ion, the position detector being situated to respond to the position of the quantity of charged particles from the multiplier produced by each incident ion.

The position detector may comprise, for example, a wire array, a resistive anode or a photodiode array which responds directly to the quantity of charged particles. Generally, the quantity of charged particles will be electrons and a preferred form of charged particle multiplier is a microchannel plate arrangement.

However, preferably the position detector comprises a plate bearing electrodes which are shaped differentially in X and Y coordinate directions and electrically connected to give outputs on coordinate leads representative of the coordinate position of incidence on the electrodes of the quantity of charged particles.

Essentially, the invention relies upon the processing of ion information serially as the ions reach the detector arrangement in turn. Serial processing allows timing signals to be used to correlate the individual ion positions with their species. Such serial processing differs in concept from the parallel presentation on the screen of a field ion microscope or an imaging atom probe. Also, it does not require the provision of a very large number of parallel processing channels. However, there are restrictions imposed by serial processing. Firstly, processing must be fast enough to allow successive ions to be dealt with. While, under some circumstances, it is possible to envisage the use of a single processing channel, inherent electrical delays in the processing equipment will generally make it advisable to cycle the processing of information

EP 0 231 247 B1

from successive ions through a set of processing channels which are gated in turn. However, the number of channels need not be large.

Secondly, it is possible that more than one ion of a particular species may be liberted from the specimen at the same time. Consequently, such ions will arrive at the detector simultaneously at different positions. Under these circumstances, the system cannot identify the different positions. With correct operation of the system, this is found to be of little significance, but it is necessary to know that the situation has arisen so that the information can be automatically disregarded. Preferably, means are provided responsive to the total number of ions received in a given time interval to identify simultaneous arrival of ions and to effect automatic disregard of the associated positional information. If such simultaneous arrivals are found to occur more often than is desirable, it is possible to reduce automatically the number of ions evaporated at each pulse by reducing the magnitude of the pulse, be it voltage or laser.

The invention will further be described with reference to the accompanying drawings, of which:—

Figure 1 is a schematic diagram of an atom probe in accordance with the invention.

Figure 2 is a diagram showing at (a) and (b) two possible configurations of ion detector arrangement for use in the atom probe of Figure 1.

Figure 3 is a diagram of the position detector of the atom probe of Figure 1.

Figure 4 is a schematic block diagram of the atom probe and associated circuitry.

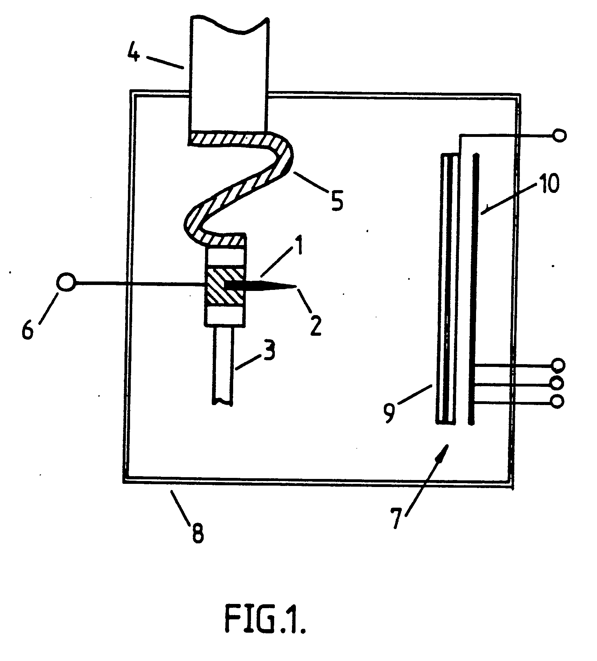

Referring to Figure 1, there is shown a specimen 1 made from the material to be analysed, and shaped by mechanical, chemical or other means into a fine needle point 2, held in a support means 3. The said support means 3 may also include some means for linear translation of the specimen in any direction and rotation of the specimen about a point approximately coincident with the pointed end of the specimen. The instrument includes:

a) means (not shown) to cool the specimen to cryogenic temperatures (in the range 20—100K) either by liquefied gases or by a closed-cycle refrigerator or other means, and coupled thermally to the specimen by a rigid member 4 and a flexible thermal connection 5,

b) means to supply to the specimen a high d.c. voltage, in the range 0—30 kV, via a terminal 6,

c) means to supply to the specimen a high voltage pulse of amplitude in the range approximately 0—5 kV, risetime about 0.5 nanoseconds, and duration about 10 nanoseconds, also via terminal 6,

d) means (not shown in Figure 1) to allow irradiation of the specimen with a laser pulse of duration about 5 nanoseconds and energy density of approximately 10 mJ/cm$^2$, and

e) an ion detector arrangement 7 to detect ions field evaporated from the specimen surface by either the said voltage pulse means or by the said laser pulse means, in combination with the said d.c. voltage means, the said detector means generating electronic pulses which may then be analysed by electronic means to determine both the time-of-flight of the ion and its position of impact on the detector means.

The specimen and detector, and any necessary parts of a—e are held within an air-tight chamber 8 having conducting walls, typically of stainless steel, and having regions of transparent walling where it is necessary to view the inside of the chamber. Means are provided to evacuate the chamber of atmosphere, down to a pressure of about $10^{-10}$ mbar. There are also means to exchange the specimen held in the support means, and means to admit a gas (e.g. neon, argon), at the discretion of the operator, to a pressure of approximately $10^{-5}$ mbar.

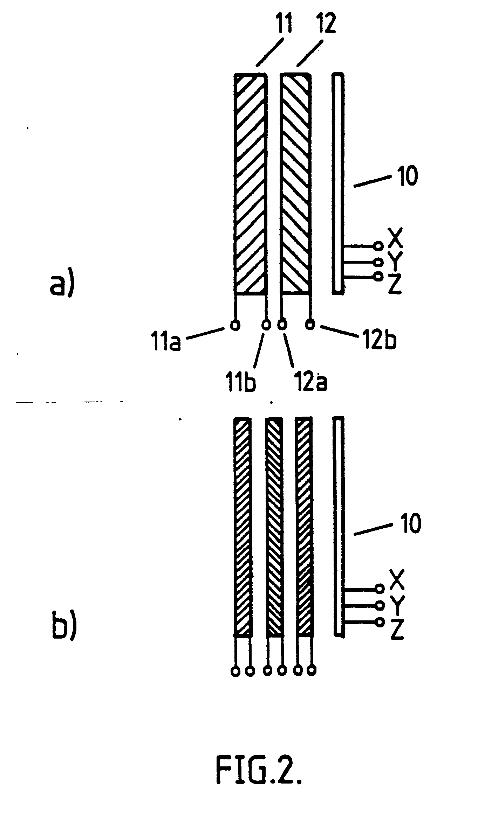

The arrangement 7 consists of a charged particle multiplier comprising of a plurality of microchannel plates 9 and a position detector 10 in the form of a shaped electrode assembly, on an insulating substrate, placed behind the said multiplier, in order to collect the charge produced as a result of the impingement of an ion upon the front surface of the detector arrangement. As shown in Figure 2, each microchannel plate 11, 12 is constructed from a resistive glassy material so as to consist of many small usually circular channels, the length of each being much greater than its width, distributed across its area so as to have their entrances and exits on opposite faces of the plate. The two faces of the plate are coated with a conductive material to allow a voltage to be applied via the terminals 11a, 11b, 12a and 12b. The material of the plate is such that a charged particle strike the wall of a channel will produce a number of secondary electrons. Thus impingement of one ion upon the detector surface will lead to the deposition of about $10^6$ electrons upon the position detector 10. The voltages applied across the assembly may vary according to the configuration and conditions, but each plate will typically have about 1 kV across it. Figure 2a shows the use of two double thickness channel plates. Figure 2b shows three single thickness channel plates. Here single thickness applies to plates which have a ratio of channel length to channel width of about 40. Double thickness plates have a channel length-to-width ratio of at least 60.

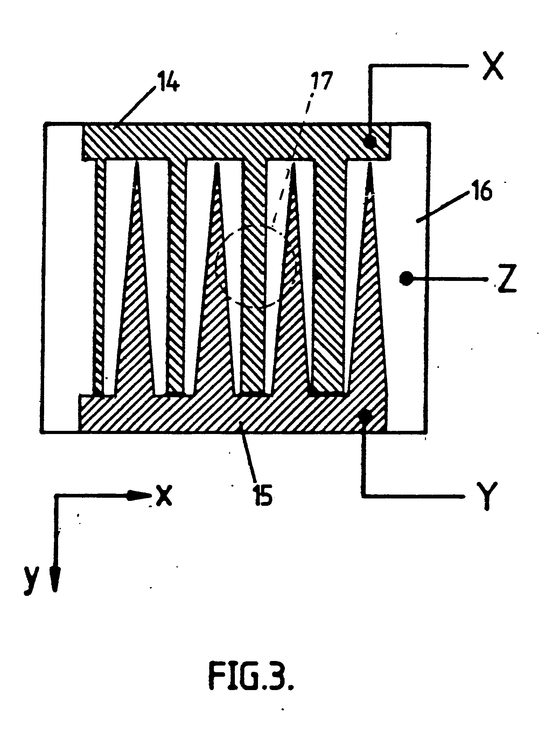

The arrangement of the electrodes of the position detector are such that the charge received is divided between at least two electrodes such that the proportion of charge collected by the electrodes is dependent on the point of impact of the ion on the front surface of the position detector. One possible arrangement, shown schematically in Figure 3, divides the charge between three electrodes 14, 15 and 16 such that the charge on the X electrode increases with the x ordinate of the ion, up to a maximum of half of the total charge, the charge on the Y electrode increases with the y ordinate of the position, up to half of the total charge, and the Z electrode collects the remaining charge. A charge signal can also be derived from the output of the channel plate closest to the position sensing means, amounting to the total charge deposited on the X, Y and Z electrodes. In Figure 3 the effective diameter of the electron "beam" from the multiplier is shown at 17. It is to be understood that for the sake of illustration the electrode pattern of Figure 3 is not to

4

scale. In practice, it will be very much finer.

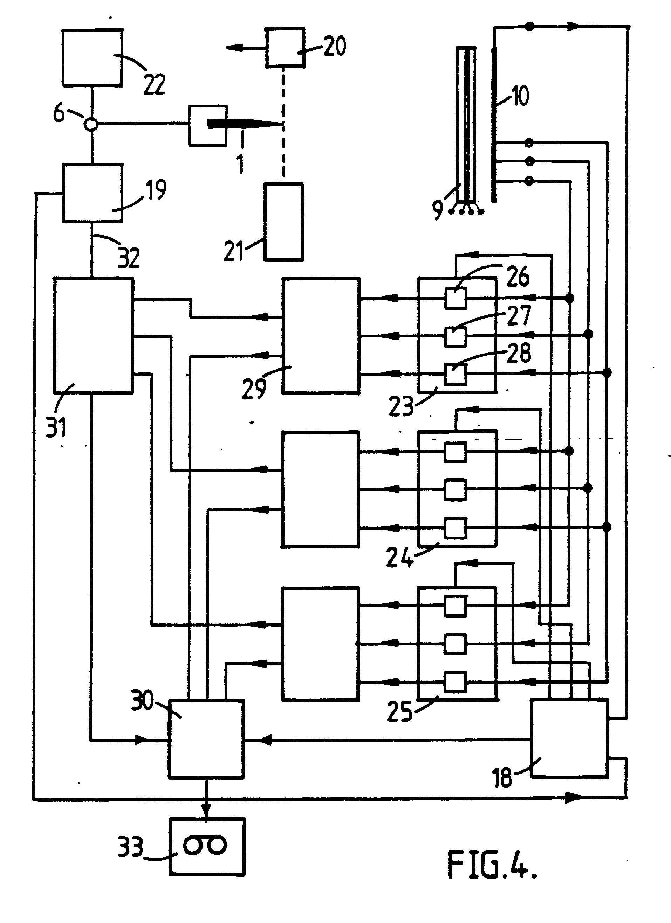

The instrument uses electronic means to measure the time-of-flight of each ion and the quantity of charge collected on each electrode as a result of the impact of each ion on the detector surface. Referring to Figure 4, the timing means consists of a multi-event time-to-digital converter 18 which will measure the intervals between a start pulse and several stop pulses applied to it. A start pulse is obtained either by picking off a small fraction of the pulse voltage from the pulse generator 19 or by using the signal from a photodiode 20 irradiated with a portion of the laser pulse from the laser 21, depending on which pulse means is being used. The bias voltage generator is shown at 22. Stop pulses may be derived either from the sum of the pulses from the X, Y and Z electrodes, or from the output of the channel plate, as above. These pulses are amplified by electronic means, placed close to the detecting means, before being routed to the time and charge measuring means.

The charge measuring means consists of three channels 23, 24, 25, each containing three charge sensitive analogue-to-digital converters, e.g. 26, 27, 28, which may be gated by a separate signal from unit 18 to determine the period during which each converter is active. During this period, charge arriving at the input to each converter in the gated channel is integrated, such that the total charge input during the period is measured. The charge output from the electrodes X, Y and Z, amplified by suitable electronic means as above, is divided equally between the charge measuring channels by a suitable resistor divider. On the arrival of an ion at the detector means, one of the channels is gated to measure the charge on each of the electrodes X, Y and Z due to this ion. On the arrival of a subsequent ion, a second channel is gated to measure the charges due to this second ion. In this way, the charges on the electrodes due to several ions can be measured, up to a maximum number of ions equal to the maximum number of charge measuring channels, and given that no two ions arrive within a single gating time of the charge measuring means. Alternatively, a single channel, working sufficiently quickly, may be used to make several measurements, removing the need for other channels. The minimum possible gating time (or integrating time) of the charge measuring channels will depend on the exact details of the electronic configuration, such as the time constant of the amplifying means. The gating time must therefore be sufficiently long to ensure a measurement of the collected charge to the accuracy required for the determination of ion positions. Timing correlation between the time-of-flight output from unit 18 and the position output from channels 23 to 25 is effected in a correlation unit 30.

In the event that two ions arrive within a single gating time, the position sensing means described above cannot be used to determine the position of the two ions. This case is therefore detected to prevent the incorrect determination of ion positions. Such a coincident arrival of two ions can be detected either by the timing means, if the ions are separated by greater than the pulse pair resolution of the timing means, or by the total charge arising from the two ions striking the detector means. For detector means using suitable multiplication means, as in Figure 2, the total charge produced by a single ion is approximately constant. The coincident impact of two ions on the detecting means will thus result in twice the charge generated by a single ion. In Figure 4, a coincidence signal is given under these circumstances from channel 23 to 25 over a line to an inhibit unit 31 via a charge to position coordinate converter 29. Unit 31 applies an output to unit 30 to inhibit processing of the positional information. The pulse intensity may be reduced via line 32.

Once the times and charges have been measured, the ion positions and mass-to-charge ratios can be calculated. This may be effected by transferring the measurements of time and charge to an on-line computer, which may then carry out the necessary calculations. As an intermediate measure, the data may be recorded on a magnetic or other medium, as indicated at 33. For charge $Q_x$, $Q_y$ and $Q_z$ collected on the X, Y and Z electrodes respectively, the ion position is given by:

$$x = \frac{2Q_x}{Q_x + Q_y + Q_z}$$

$$y = \frac{2Q_y}{Q_x + Q_y + Q_z}$$

The total charge may also be obtained by measuring the charge from the channel plate output, T, in place of the charge on the Z electrode, in which case the ion position is calculated using:

$$x = 2Q_x/Q_t$$

$$y = 2Q_y/Q_t$$

For specimen voltage $V_{dc}$ and pulse amplitude $V_{pul}$, the ion mass-to-charge ratio is given by:

$$m/n = \frac{1.93 \times 10^{-4}}{d^2}(V_{dc} + bV_{pul})t^2$$

EP 0 231 247 B1

where t is the flight time in nanoseconds, d is the flight length (mm) and b is an experimental factor (approximately 1) to allow for attenuation of the voltage pulse due, for example, to impedance mis-match at the specimen. When two or more ions have been detected coincidentally, as described above, only the mass-to-charge ratios can be calculated. Once position and mass-to-charge data have been obtained, these may be stored and used to calculate the chemical analysis from all or part of the sampled area, and from all or part of the analysed depth. The spatial distribution of a given species or group of species may also be calculated, inclusively in three dimensions, since the order of detection of the ions gives a measure of the depth from the original surface.

The position sensing means may be made from a transparent electrode material on a transparent substrate, and coated with a phosphorescent material to allow simultaneous imaging of the detected ions. This will also allow field-ion images of the specimen surface to be observed, by introducing a small quantity of gas into the instrument, as previously described. Means to carry out time gating of field evaporated species may also be incorporated, either by applying a pulse of approximately 1 kV to the output of the channel plate assembly, or by applying a pulse of about 100V between two of the channel plates in the assembly. Multiple pulses may also be applied, to image species of more than one time-of-flight, e.g. carbon species at m/n=6 ($C^{++}$), 12 ($C^+$), 24 ($C_2^+$) etc. In the absence of the image facility, field ion images may be reconstructed by determining the positions of the field-ionised gas atoms incident on the detector means, as above. A second imaging means, such as a single channel plate and phosphor screen, may also be included in the instrument.

The invention is not restricted to the details of the embodiment described with reference to the accompanying drawings. For example, correlation of positional and time-of-flight signals has been described as being effected by electronic circuit units. Provided timing signals are associated, however, these time-of-flight and positional signals can be recorded for subsequent processing and correlation, perhaps by computer. The number of charge measuring and other channels is also not restricted to the numbers which have been quoted for purposes of illustration.

## Claims

1. An atom probe comprising a specimen holder for holding a specimen to be examined; means for field evaporating ions from the surface of the specimen; an ion detector arrangement for receiving the ions; a position detector responsive to the incidence of the ions on the detector arrangement; and timing means for determining the times-of-flight of the ions from the specimen to the detector arrangement and thereby allowing the ion species to be identified, characterised in that the position detector (10) is effective to produce sequential electrical position signals representative of the position of incidence of the ions on the detector arrangement (7) and further characterised in that correlating means (30) are provided for serially processing the said position signals representative of different positions of incidence of the ions under the control of timing signals derived from the timing means (18) so as to enable the species of each ion to be identified with the ion position.

2. An atom probe as claimed in claim 1 wherein the detector arrangement comprises a charged particle multiplier (9) for producing a quantity of charged particles corresponding in amount and position to the number of ions incident and the respective positions of incidence of each ion, the position detector being situated to respond to the position of the quantity of charged particles from the multiplier produced by each incident ion.

3. An atom probe as claimed in claim 2 wherein the position detector comprises a plate bearing electrodes (14, 15, 16) which are shaped differentially in X and Y coordinate directions and electrically connected to give outputs on coordinate leads representative of the coordinate position of incidence on the electrodes of the quantity of charged particles.

4. An atom probe as claimed in any of the preceding claims wherein the ion detector arrangement gives an output representative of the total ion charge received in a given time interval, and there are provided means responsive to said total ion charge to identify simultaneous arrival of ions and to effect automatic disregard of the associated positional information.

5. An atom probe as claimed in any of the preceding claims wherein means are provided for regulation of the means for field evaporating ions in response to rate of arrival of ions at the detector, as indicated by the total ion charge collected.

6. An atom probe as claimed in any of the preceding claims including means (33) for storing the outputs from the timing means and the ion detector arrangement, or signals derived therefrom, with time correlation information, for subsequent computer processing.

7. An atom probe as claimed in any of the preceding claims wherein a plurality of measuring channels is provided, connected to measure the output from the position detector, and gating means is effective under control of the timing signals to gate the output from the position detector to the different channels in turn, whereby the positions of successive ions are measured in different channels.

## Patentansprüche

1. Atom-Untersuchungseinrichtung, umfassend einen Probenhalter zum Halten einer zu

6

untersuchenden Probe; Einrichtungen zu Feld-Verdampfung von Ionen aus der Oberfläche der Probe; eine Ionendetektoranordnung zum Aufnehmen der Ionen; einen Positionsdetektor, der auf den Einfall der Ionen auf der Detektoranordnung antwortet und Zeitgebereinrichtungen, um die Flugzeit der Ionen von der Probe zur Detektoranordnung festzustellen und dadurch eine Identifizierung der Ionenart zu erlauben, dadurch gekennzeichnet, daß der Positionsdetektor (10) sequenzielle elektrische Positionssignale abgeben kann, welche repräsentativ für die Einfallpositionen der Ionen auf der Detektoranordnung (7) sind, und weiterhin dadurch gekennzeichnet, daß Korrelationseinrichtungen (30) vorgesehen sind, um die für die Einfallpositionen der Ionen repräsentativen Positionssignale seriell zu verarbeiten, und zwar unter einer Steuerung der Zeitgebersignale aus den Zeitgebereinrichtungen (18), um so eine Identifizierung der Art eines jeden Ions mit der Ionenposition zu ermöglichen.

2. Atom-Untersuchungseinrichtung nach Anspruch 1, wobei die Detektoranordnung einen Vervielfacher (9) für geladene Partikel umfaßt, um eine Menge von geladenen Partikeln zu erzeugen, die in Größe und Position der Anzahl von einfallenden Ionen und den jeweiligen Einfallpositionen eines jedens Ions entsprechen, wobei der Positionsdetektor so angeordnet ist, daß er auf die Position der Menge von geladenen Partikeln aus dem Vervielfacher, welche durch jedes einfallende Ion produziert wird, antwortet.

3. Atom-Untersuchungseinrichtung nach Anspruch 2, wobei der Positionsdetektor eine Platte umfaßt, die Elektroden (14, 15, 16) trägt, welche in X- und Y-Koordinatenrichtungen differentiell geformt und elektrisch so verbunden sind, daß sie Ausgänge auf Koordinatenleitungen geben, welche für die Koordinatenpositionen der Einfälle der Mengen von geladenen Partikeln auf den Elektroden repräsentativ sind.

4. Atom-Untersuchungseinrichtung nach einem der vorhergehenden Ansprüche, wobei die Ionendetektoranordnung einen Ausgang abgibt, welcher für die gesamte Ionenladung, die während eines vorgegebenen Zeitintervalls empfangen wurde, repräsentativ ist, und wobei Einrichtungen vorgesehen sind, welche auf die gesamte Ionenladung ansprechen, um eine gleichzeitige Ankunft von Ionen festzustellen und eine automatische Außerbetrachtlassung der zugehörigen Positionsinformation zu bewirken.

5. Atom-Untersuchungseinrichtung nach einem der vorhergehenden Ansprüche, wobei Einrichtungen vorgesehen sind, um die Einrichtungen zur Feldverdampfung von Ionen in Antwort auf die Ankunftsrate von Ionen auf dem Detektor wie durch die gesammelte Gesamtionenladung angezeigt zu regulieren.

6. Atom-Untersuchungseinrichtung nach einem der vorhergehenden Ansprüche, umfassend Einrichtungen zum Speichern der Ausgänge der Zeitgebereinrichtungen und der Ionendetektoranordnung oder hiervon abgeleiteter Signale mit Zeitkorrelationsinformationen, um diese nachfolgend in einem Computer zu verarbeiten.

7. Atom-Untersuchungseinrichtung nach einem der vorhergehenden Ansprüche, wobei eine Vielzhal von Meßkanälen vorgesehen ist, welche zur Messung der Ausgänge des Positionsdetektors verbunden sind und wobei eine Gattereinrichtung unter Steuerung der Zeitgebersignale wirkt, um den Ausgang vom Positionsdetektor gegenüber den verschiedenen Kanälen gatter- oder fenstermäßig zu steuern, wodurch die Positionen aufeinanderfolgender Ionen in verschiedenen Kanälen gemessen werden.

**Revendications**

1. Sonde d'analyse atomique comportant un support d'échantillon pour recevoir un échantillon à examiner; des moyens pour provoquer l'évaporation d'ions par effet de champ à partir de la surface de l'échantillon, un dispositif détecteur d'ions pour recevoir lesdits ions, un détecteur de position sensible à l'incidence des ions sur le dispositif détecteur et des moyens de synchronisation pour déterminer le temps de transit de l'échantillon au dispositif détecteur et permettre ainsi d'identifier les espèces ioniques, caractérisée en ce que le détecteur de position (10) est propre à fournir des signaux électriques de position séquentiels traduisant la position d'incidence desdits ions sur le dispositif détecteur (7), et caractérisé en outre en ce que les ions en ce qu'il est prévu des moyens de corrélation (30) pour traiter en série lesdits signaux de position traduisant différentes positions d'incidence des ions sous la commande de signaux provenant desdits moyens de synchronisation (18) afin de pouvoir identifier l'espèce de chaque ion avec sa position.

2. Sonde atomique suivant la revendication 1, caractérisée en ce que le dispositif détecteur comporte un multiplicateur de particules chargées (9) pour produire une quantité de particules chargées correspondant en importance et en position au nombre d'ions incidents et aux positions d'incidence respectives de chaque ion, le détecteur de position étant situé de manière à être sensible à la position de la quantité de particules chargées issues du multiplicateur produite par chaque ion incident.

3. Sonde atomique selon la revendication 2 caractérisée en ce que le détecteur de position comporte une plaque portant des électrodes (14, 15, 16) conformées différentiellement en directions de coordonnées X et Y et reliées électriquement pour fournir en sortie sur des conducteurs de coordonnées des informations traduisant la position en coordonnées de l'incidence sur les électrodes de la quantité de particules chargées.

4. Sonde atomique suivant l'une quelconque des revendications précédentes, caractérisée en ce que le dispositif détecteur d'ions fournit une information de sortie traduisant la charge ionique totale reçue dans un intervalle de temps déterminé, et en ce qu'il est prévu des moyens sensibles à ladite charge ionique totale pour identifier une arrivée simultanée d'ions et pour assurer automatiquement que l'information de position associée ne soit pas prise en compte.

5. Sonde atomique suivant l'une quelconque des revendications précédentes, caractérisée en ce qu'il est prévu des moyens de régulation desdits moyens d'évaporation d'ions par effet de champ en réponse au taux d'arrivée des ions audit détecteur, tel qu'indiqué par la charge ionique totale collectée.

6. Sonde atomique suivant l'une quelconque des revendications précédentes, comportant des moyens pour mémoriser les informations de sortie desdits moyens de synchronisation et dudit dispositif détecteur d'ions, ou des signaux en dérivant, ainsi que des informations de corrélation temporelle, en vue d'un traitement informatique ultérieur.

7. Sonde atomique suivant l'une quelconque des revendications précédentes, caractérisée en ce qu'il est prévu une pluralité de canaux de mesure reliés de manière à mesurer les informations de sortie dudit détecteur de position, et en ce que des moyens à portes électroniques assurent sous la commande desdits signaux de synchronisation la transmission des informations de sortie du détecteur de position auxdits différents canaux de sorte que les positions d'ions successifs sont mesurées dans des canaux différents.

FIG.1.

FIG.2.

FIG.3.

FIG.4.